# EUROPEAN PATENT APPLICATION

(11) **EP 4 741 852 A1**
(43) Date of publication of application: **13.05.2026**
(21) Application number: 24383213.6
(22) Date of filing: 06.11.2024
(51) Int. Cl.: G01R 31/389, G01R 31/396

(54) **ELECTROCHEMICAL IMPEDANCE SPECTROSCOPY SYSTEM AND METHOD**

(71) Applicant: Ficosa Automotive, S.L.U., 08232 Viladecavalls (ES)
(72) Inventor: BAUTISTA FLORENSA, Roger, Viladecavalls, Barcelona (ES); GÓMEZ NÚÑEZ, Alberto, Viladecavalls, Barcelona (ES)
(74) Representative: Bardehle Pagenberg S.L.

(57) **Abstract**

An electrochemical impedance system comprising a vehicle battery, a battery management system (BMS), an excitation power module, and a current sensor. The vehicle battery comprises, in turn, one, two or more battery modules. Each battery module includes a plurality of battery cells. The BMS is configured to control the excitation power module to excite at least the one, two or more battery modules. The current sensor is configured to sense at least electric current of the one, two or more battery modules. The BMS is further configured to sense, determine, or receive voltage of the plurality of battery cells of the one, two or more battery modules, and also receive the electric current of the one, two or more battery modules sensed by the current sensor. In this way, the system of the present disclosure is capable of determining the electrochemical impedance of the vehicle battery. It includes two options: the first option, wherein the BMS is configured to determine the impedance of the plurality of battery cells of the one, two or more battery modules based at least on the electric current and the voltage. Alternatively, the second option, wherein the BMS is configured to send the electric current and the voltage to an external controller configured to determine the impedance of the plurality of battery cells of the one, two or more battery modules based at least on the electric current and the voltage. Additionally, the system may be further configured to generate a battery cell degradation output based at least on the determined impedance. The corresponding method is also provided.

## Description

### FIELD OF TECHNOLOGY

The present application relates an electrochemical impedance spectroscopy system. The electrochemical impedance spectroscopy system is configured to determine an electrochemical impedance of a vehicle battery. For this, the system is provided with a battery management system that controls an excitation power module configured to excite the vehicle battery. The system may be further configured to generate a battery cell degradation output based at least on the determined impedance. The corresponding method is also provided.

### BACKGROUND

Electric vehicles have at least an electric motor and a vehicle battery. In operation, the electric motor is adapted to provide propulsion to the vehicle, e.g., to drive the transmission connected to the vehicle wheels. Electric vehicles may be pure electric vehicles, only-electric vehicles or all-electric vehicles. Electric vehicles may also include hybrid electric vehicles which combines a conventional internal combustion engine system with an electric propulsion.

Different types of batteries are used to power electric motors. Lithium-ion batteries are the most utilized technology in electric vehicles. However, other types of vehicle batteries are known. In any case, it is of vital importance to operate vehicle batteries in pre-defined safety limits to ensure the safety of the user as well as the electric vehicle.

In use, vehicle batteries suffer from aging, wearing, or degradation. The monitoring and control of (high-voltage) vehicle batteries in electric vehicles throughout their lifespan aim to maximize efficiency while extending their remaining useful life.

The state of health or SOH of a vehicle battery refers to a measure of the current condition or performance of the vehicle battery compared to its ideal or original state when it was new. SOH is typically expressed as a percentage, where 100% indicates a vehicle battery that is in perfect condition, and lower percentages represent aging, wear, or degradation. In fact, SOH helps in assessing the remaining useful life of the vehicle battery and indicates when it may need replacement or maintenance.

Improvement and optimization of energy management and the enhancement of battery lifespan are crucial topics in the automotive industry. Recent innovations in computation and electronics present remarkable advances for implementation in battery control. The use of novel artificial intelligence and other predictive models can contribute to improving the precision of battery state estimations. The remaining useful life of the battery is closely related to the SOH.

Additionally, battery degradation can result in hazardous events, with thermal runaway being the most well-known. The state of safety or SOS of a vehicle battery refers to the assessment of the battery's safety status, ensuring it operates without posing risks such as fire, explosion, leakage, or other hazardous conditions. SOS evaluates the vehicle battery's ability to function safely under normal and stressful conditions, including temperature extremes, overcharging, physically damage, and other environmental factors. Thus, monitoring the SOS is also a prominent indicator to consider in the technological field of electric vehicles.

The state of charge or SOC may be defined as an indication of the current charge level of the vehicle battery, typically as a percentage, showing how much energy is available for use. Existing algorithms yield remarkable results in estimating the SOC; however, the SOH requires more complex algorithms, and the SOS is still challenging to calculate for electric vehicle batteries.

In known prior art, algorithms used in battery management systems for SOH and SOS rely on measured signals from the vehicle battery. Particularly, known battery management systems utilize direct measurements, such as voltage, electric current, and temperature, to calculate these indicators. However, the accuracy of these calculations depends on the performance of the underlying algorithms.

It would be therefore desirable to provide a system and method for determining an electrochemical impedance of a vehicle battery in order to obviate the above-mentioned drawbacks and to provide advantageous solutions to the shortcomings in the prior art.

### SUMMARY

It is an object of the present invention to provide an electrochemical impedance spectroscopy system configured at least to determine an electrochemical impedance of a vehicle battery. The electrochemical impedance spectroscopy system is referred hereinafter as the system for clarity and conciseness reasons.

The system comprises a vehicle battery, a battery management system or BMS. A plurality of voltage sensors may be further provided preferably as part of the battery management system. The system further comprises an excitation power module, and a current sensor.

The vehicle battery is arranged within a motor vehicle (for driving the motor(s) configured) to move the wheels thereof as required. The vehicle battery may be a high-voltage battery used in electric vehicles and hybrid vehicles. The vehicle battery may operate with a voltage higher than 100 volts, for example, within a voltage range of 200 volts to 1000 volts. The exact voltage depends on the vehicle type and the manufacturer's design. In fact, the vehicle battery is a rechargeable battery used to supply electric power to electric vehicle, e.g., to an electric power operated system (explained further below). The primary function of the vehicle battery is to provide the necessary electric power to the electric power operated system, e.g., to the traction system. Furthermore, the vehicle battery may also power low voltage systems that may include auxiliary electrical components such as lights, infotainment systems, and sensors.

The vehicle battery comprises one, two or more battery modules. Each battery module includes a plurality of battery cells. That is, the vehicle battery comprises at least one battery module, i.e., a first battery module. Said first battery module includes a plurality of battery cells arranged one next to the other. The vehicle battery may preferably comprise a second battery module that, in turn, may include a plurality of battery cells arranged one next to the other. A third battery module and further battery modules may be of course provided in the vehicle battery.

Each of the plurality of voltage sensors may be electrically connected to the one, two or more battery modules (i.e., at least to the first and/or second battery modules). Each voltage sensor may be configured to sense at least voltage of one or more battery cells (e.g., a group of battery cells). The battery management system may comprise a cell monitoring controller or CMC that may include said plurality of voltage sensors.

The excitation power module also referred herein as EIS excitation generator (or excitation power converter) is electrically connected to the vehicle battery (e.g., to the one, two or more battery modules) and the battery management system. The excitation power module may be configured to excite at least the one, two or more battery modules. That is, the excitation power module may generate electric power with a non-constant current perturbation to be received by the battery cells. For this, the battery management system is configured to control the excitation power module as required.

The current sensor may be configured to sense at least electric current of the one, two or more battery modules (i.e., at least to the first and/or second battery modules). The current sensor may be connected to the one, two or more battery modules (i.e., at least to the first and/or second battery modules).

As explained above, the system is configured at least to determine the electrochemical impedance of the vehicle battery. The electrochemical impedance of the vehicle battery refers to the opposition that a battery's electrochemical structure presents to the flow of alternating current over a range of frequencies. It combines both resistive and reactive components of the vehicle battery's internal resistance and provides insights into different processes occurring within the vehicle battery, such as charge transfer, diffusion, and double-layer capacitance. That is, the system is configured to perform the electrochemical impedance spectroscopy to determine the internal impedance value of the system, in this specific application, battery cells. The impedance of the battery cells has resistance and reactance values, in consequence, the impedance is a complex value. To calculate it, electric current and voltage through the battery cell are measured and then Ohm's Law is applied to calculate impedance's magnitude and the phase is obtained from phase variations. The determination of the electrochemical impedance may be conducted under a potentiostatic technique or a galvanostatic technique.

The potentiostatic mode or technique comprises applying a constant direct-current potential with a superimposed non-constant (or alternate-current / sine-wave) perturbation. The input or excitation input signal is the potential (or voltage) and the resulting current response is measured, both measured with sensors.

The galvanostatic mode or technique comprises applying a constant current with a small non-constant current perturbation. In this case, the excitation input signal is the current and the resulting voltage response is measured.

For determining the impedance, the system requires to study a frequency spectra analysis of the impedance so as to determine the reactance value of the battery cell. Therefore, the system involves low-frequency to high-frequency (e.g., 0.1 - 4000 Hz) voltage and current signals. The excitation input signal is expected to be non-constant, which ideally, should be a sine-wave. However, if a frequency analysis is conducted from the measured signals, other non-continuous signals can be applied, such as square-wave.

The (current or voltage) excitation input signal (galvanostatic or potentiostatic mode) is controlled by the battery management system. The excitation input signal may be generated with a unique excitation input signal for the one, two or more battery modules. The voltage perturbation response may be measured at the plurality of battery cells level, wherein the current perturbation response may be measured at the two or more battery modules level in order to have a successful characterization of the impedance of the plurality of battery cells. The measured signal generally goes to an analog-to-digital interface to be then processed to calculate the impedance. In any case, the excitation signal though the battery cell may be small enough to not modify the battery cell conditions, alike the state of charge.

Battery cells are inherently non-linear systems; however, impedance can only be defined or calculated for linear systems. The impedance of a cell may be approximated if linear time-invariant conditions are assumed. Linearization of such a system requires the following:
- Causality: The system's response to perturbation must be generated solely as a result of the applied perturbation or excitation signal.
- Linearity: The relationship between perturbation and response must adhere to linear differential laws.
- Stationarity: The system should exhibit minimal variation with respect to environmental conditions, specifically the state of charge, temperature, and voltage level of the cell.
- Stability: The system must remain stable over time, meaning it should return to its initial state once the perturbation is removed.

The battery management system or BMS is electrically connected to the vehicle battery. In fact, the battery management system is configured at least to control the vehicle battery. The BMS may be responsible of the data and signal acquisition from the vehicle battery and perform, at least, a basic control including direct operation over battery pack components and communicate with other controllers. For example, the BMS is configured to receive multiple measurements of the vehicle battery including at least one of: current, cell voltages, and one or more temperatures. Additionally, the BMS may receive measurements such as gas (e.g., H2, CO, CO2), pressure, isolation and leakage. The BMS processes these values which can be transmitted to an external controller such as a vehicle controller through bus communication channels. Additionally, these measurements (or instructions or commands) received by the bus communication channel may be used by the BMS to directly operate battery pack components alike junction-box contactors / relays, operate thermal management system, balance battery cells or calculate estimation parameters of the battery status alike state of charge (SOC) or state of health (SOH).

In use, the battery management system is configured to particularly sense or determine voltage of the plurality of battery cells of the one, two or more battery modules (i.e., at least to the first and/or second battery modules). Also, the battery management system is configured to receive the electric current of the one, two or more battery modules (i.e., at least to the first and/or second battery modules) sensed by the current sensor.

Thanks to the present system, the impedance of the plurality of battery cells may be calculated, estimated or determined derived at least in part from the electric current and the voltage. There may be two options to determine the impedance of the plurality of battery cells:
FIRST: the battery management system is configured to determine the impedance of the plurality of battery cells of the one, two or more battery modules based at least on the electric current and the voltage.
SECOND: the battery management system is configured to send the electric current and the voltages to the external controller configured to determine the impedance of the plurality of battery cells of the one, two or more battery modules based at least on the electric current and the voltage(s).

The system may be further configured to monitor an electrochemical degradation of the battery cell by determining the impedance variation compared to one or more previous measurements. In fact, an outcome of the electrochemical impedance spectroscopy may be to monitor the degradation of the battery cells and also may be used to detected hazardous events such as an early-warning of a thermal runaway.

In any case, a preliminary analysis or study of the battery cell impedance at beginning of life is to be conducted. To enable this analysis, a data set is available, obtained through prior aging tests in which the impedance data is determined at each stage. This approach allows calculation of the degradation status of the cell over its lifecycle within the vehicle. Then, the electrochemical impedance spectroscopy results may be compared to the one or more previous measurements and the impedance variations may be used to determine a more precise real-time battery estimation values for example.

A preliminary analysis or study of the battery cell impedance at the beginning of life may be performed. To enable this analysis, a data set is available, obtained through prior aging tests in which the impedance data is determined at each stage. This approach allows calculation of the degradation status of the cell over its lifecycle within the vehicle.

The precision of the impedance results depends on the voltage and current sensors. The resolution and accuracy of the measurements may preferably be according to the requirements of the Kramers-Kronig conditions, to ensure the cell linear response and the stable conditions. Thus, if a small amplitude perturbance response is expected, the resolution of the sensor is to be dimensioned accordingly because the phase difference detection precision is crucial to measure the impedance.

It is preferred that the current sensor is a single current sensor electrically, i.e., a single unit current sensor. The current sensor is configured to sense at least electric current of the two or more battery modules (at least to the first and second battery modules). For this, the current sensor may be connected (directly or indirectly) to two or more battery modules (at least to the first and second battery modules). The reason to use one single current sensor is because the vehicle-battery configuration is known in advance. If all the battery cells are connected in a series group, the current at each is the one measured. If parallel groups exist, an assumption of equivalent load distribution can be performed. If there exist imbalances, the measured voltages may present different voltage responses for a whole parallel group. The use of one single current sensor for the electrochemical impedance spectroscopy may contribute in a cost reduction of the solution with a simplified solution where the current measurement may be used (at the same time) for both power converter in its control loop, and in the BMS for the impedance calculation.

The current sensor may be electrically arranged therebetween the excitation power module and the vehicle battery. The term 'therebetween' is to be understood such that the current sensor may be included in the excitation power module or in the vehicle battery. It is thus possible that the current sensor may be (physically) arranged within the battery management system, a junction box (explained below), or the electric power operated system. If the current sensor is arranged in the junction box, it is not part of the electric circuit of the junction box that receives/supplies high electric power. Similarly, if the current sensor is arranged in the electric power operated system, it is not part of the electric circuit of the electric power operated system that receives/supplies high electric power. What is important is that the current sensor is in electrical connection with the electric connecting means adapted for connecting the excitation power module with the vehicle battery, regardless of its physical location.

Preferably, the excitation power module is a single excitation power module. In operation, the excitation power module is configured to excite at least two or more battery modules (the first and/or second battery modules) such as all battery modules.

It may be preferred that the excitation power module is arranged out of the vehicle battery and the battery management system. Alternatively, the excitation power module may be arranged in the junction box (in a separate electric circuit from the contactors), or in the on-board charger being an independent module from the power train (i.e., the traction system).

The excitation power module, the vehicle battery, the current sensor, and the battery management system form an electric circuit that may be electrically independent of the electric power flowing through the junction box and/or the electric power operated system received at least by the traction system.

The electric power operated system may be at least one of air conditioning system, low voltage system, an on-board charger or OBC, and a traction system (i.e., vehicle propulsion system). The traction system may include an electric power train also known as the electric motor. In particular, the electric power operated system may be provided with or connected to multiple devices. Additionally, when parking/stopped mode is expected, the junction box contactors or relays may be open, then, the vehicle battery may be isolated to perform the electrochemical impedance spectroscopy where stable conditions are ensured. If the driving mode is activated, the contactors or relays of the junction box may be closed allowing at least the traction system receiving electric power from the vehicle battery.

The present invention differentiates from most prior art in that known prior art senses the electric current of the vehicle battery through the power train and/or chargers (e.g., high-voltage circuits of the junction-box, HV-bus). On the contrary, the current sensor of the present invention is not directly connected to the rest of the (high-voltage circuit of the) electric power operated system (or, junction-box, or HV-bus) as it is directly connected to the vehicle battery itself (to the electric connecting means that connect the vehicle battery and the excitation power module). Therefore, the present invention does not involve existing elements of the battery pack (e.g., junction-box, HV-bus). As a result, the present current sensor may have different accuracy and resolution (and sampling rate) requirements compared to a current sensor directly attached to or being an integral part of the high-voltage electric circuit including the electric power operated system (or the junction-box, or HV-bus) that receives/supplies high electric power.

It is preferred that the battery management system is configured to receive a vehicle input signal. The battery management system is also configured to determine a trigger command of the system based at least on the vehicle input signal. The vehicle input signal is at least related to vehicle status and the vehicle-battery status.

The vehicle status is at least one of parking mode, ignition off, vehicle not started. Further, the vehicle-battery status comprises whether the vehicle battery receives and/or supplies electric power or not. Stability and linearity conditions in the vehicle battery can be ensured.

Preferably, the battery management system is further configured to receive or generate a starting instruction. In this way, the trigger command of the system is based on the starting instruction.

In turn, the starting instruction is based at least on one predefined event, such as a predefined time, predefined distance, and an instruction from the user or driver.

Preferably, the trigger command of the system is further based on a temperature of the vehicle battery and/or pre-set time. More preferably, the trigger command is delayed by the pre-set time or up to the temperature of the vehicle battery is lower than a pre-established temperature.

It is preferred that the vehicle input signal is received from an external controller. For example, the external controller may be arranged out of the system. Alternatively, the vehicle input signal is received (directly) through a vehicle communication channel such as a CAN-BUS communication.

Preferably, the battery management system or the external controller is configured to receive a change of the vehicle status (e.g., parking mode) or the vehicle-battery status (e.g., the electric power supplied by the vehicle battery is changed). In the event of change in the vehicle status and/or the vehicle-battery status, the battery management system or the external controller may be configured to stop determining the impedance.

The trigger command of the system may be further based on a cell balancing of the vehicle battery to ensure stable conditions. Optionally, the trigger command is delayed up to the cell balancing is completed. This ensures that all battery cells are at the same voltage level and that the impedance measurement will be uniform.

In use, the present system or the external controller (with embedded algorithms) is further configured to generate a battery cell degradation output based at least on the determined impedance. Said (embedded) algorithms may comprise an artificial intelligence module such as a trained machine learning. Alternatively, it may be a data analysis or data correlation system. Along their lifespan, the battery cells degrade losing some electrochemical properties. The degradation of the cells impacts the remaining useful life of the battery and the vehicle. If this smooth degradation is monitored the energy management of the vehicle may be tuned towards an optimized and more efficient energy usage. Additionally, the electrochemical impedance spectroscopy results can be used for forensic analysis; in case of an accident, checking the battery status; or for second-life use, determine the status of the battery and consider the application that better suits to it.

According to an aspect of the present invention, it is proposed a method of operating an electrochemical impedance spectroscopy system. The method may be used for determining an electrochemical impedance of a vehicle battery. The method comprises:
- providing a vehicle battery comprising a first battery module that includes a plurality of battery cells, and, optionally, providing a second battery module that includes a plurality of battery cells;
- electrically connecting a battery management system to the vehicle battery;
- forming an electric circuit by electrically connecting the first module and an excitation power module;
- electrically connecting the second module to the electric circuit;
- sensing, by the current sensor, electric current of the electric circuit;
- electrically connecting the excitation power module to the battery management system;
- powering the excitation power module configured to excite the electric circuit;
- receiving, by the battery management system, the electric current of the electric circuit sensed by the current sensor;
- sensing or determining voltage of the plurality of battery cells of the first battery module by the battery management system;
- optionally, sensing or determining voltage of the plurality of battery cells of the second battery module by the battery management system;
- determining, by the battery management system, the impedance of the plurality of battery cells of the first battery module (and optionally of the second battery module) based at least on the electric current and the voltage, or
   sending, by the battery management system, the electric current and the voltage to an external controller configured to determine the impedance of the plurality of battery cells of the first battery module (and optionally the second battery module) based at least on the electric current and the voltage.

The method may further comprise:
- receiving a vehicle input signal, wherein the vehicle input signal is at least related to vehicle status and the vehicle-battery status;
- determining a trigger command of the system based at least on the vehicle input signal;
- preferably, receiving or generating a starting instruction, wherein the trigger command of the system is further based on the starting instruction, optionally, the starting instruction is based at least in a pre-defined event, for example, on one of
   ∘ a predefined time,
   ∘ predefined distance, and
   ∘ an instruction from the user or driver.

### BRIEF DESCRIPTION OF THE DRAWINGS

Non-limiting examples of the present disclosure will be described in the following, with reference to the appended drawings. In the drawings:
Figure 1 is a schematic illustration of an electrochemical impedance spectroscopy system connected to an external controller, and a junction box, wherein the junction box is further connected to an electric power operated system;
Figure 2 is a schematic illustration similar to figure 1 showing an excitation input signal generated by the excitation power module as well as the electric current measured by the single-unit current sensor;

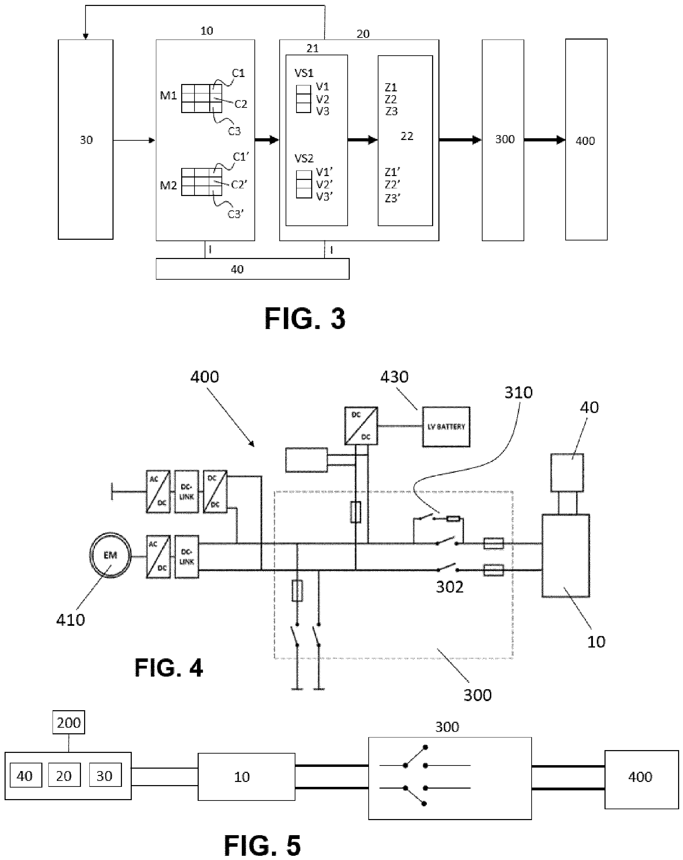

Figure 3 is a schematic illustration that shows the electrochemical impedance spectroscopy system without the vehicle battery;
Figure 4 is an overview illustration that shows the electrochemical impedance spectroscopy system implemented in a vehicle scenario; and
Figure 5 is a schematic illustration showing that the battery management system, the single-unit current sensor, and the excitation power module form an electric circuit that is electrically independent of the high electric power flowing through the junction box and/or the electric power operated system. Figure 5 further illustrates a possible vehicle implementation where the external controller is connected to the electric circuit that is connected to the vehicle battery that is connected to the junction box that is connected to the electric power operated system.

### DETAILED DESCRIPTION OF EXAMPLES

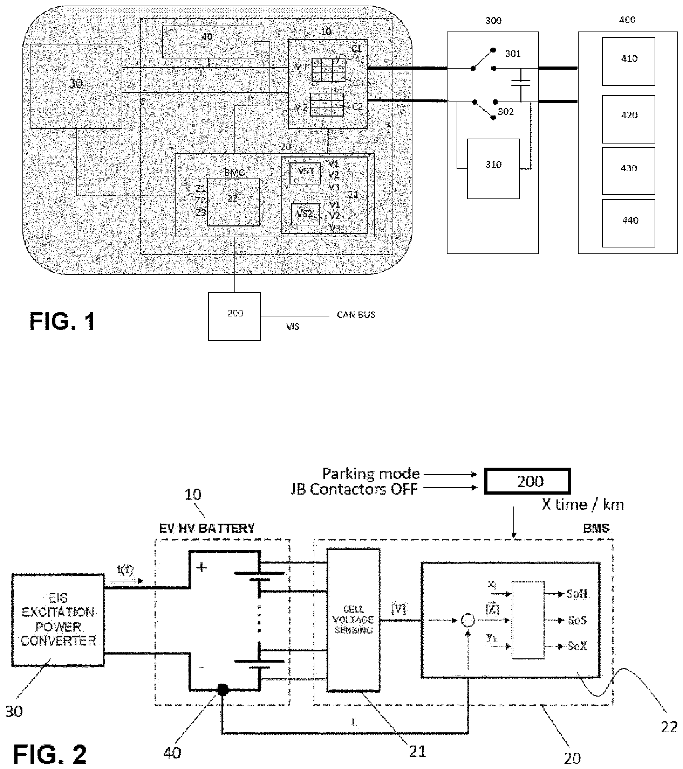

Figure 1 illustrates an electrochemical impedance spectroscopy system connected to an external controller 200 and a junction box 300. In turn, the junction box 300 is connected to an electric power operated system 400. The electrochemical impedance spectroscopy system is referred hereinafter as the system for clarity and conciseness reasons.

In the non-limiting example of figure 1, the electric power operated system 400 comprises different sub-systems such as a traction system 410, an air conditioning system 420, a low voltage system 430, and an on-board charger system 440 or OBC.

The junction box 300 is a vehicle junction box. The junction box 300 comprises contactors 301, 302 and/or relays to connect a vehicle battery 10 with the electric power operated system 400. When the contactors 301, 302 are open, the vehicle battery 10 and the electric power operated system 400 are in electrical isolation. When the contactors 301, 302 are closed, the vehicle battery 10 and the electric power operated system 400 are in electrical connection.

The external controller 200 is, in particular, a vehicle controller VCU such as a vehicle control unit. It is connected to a vehicle bus communication channel such as a CAN-bus. The external controller 200 may obtain a signal from a vehicle bus communication channel, with the CAN-bus being an example. The signal may include at least data related to a parking mode (or other vehicle modes such driving mode). If parking mode is selected, the contactors or relays of the junction box are open. If the driving mode is selected, contactors or relays of the junction box are closed.

As shown, the electrochemical impedance spectroscopy system comprises an EIS excitation power module 30, a vehicle battery 10, a battery management system 20 or BMS, and a current sensor 40.

Figure 1 shows that the vehicle battery 10 comprises two or more battery modules M1, M2. Each battery module M1, M2 includes a plurality of battery cells C1, C2, C3 (in the shown example C1, C2, C3 refer to a group of battery cells).

The battery management system (BMS) 20 is configured to control the vehicle battery 10, e.g., the two or more battery modules M1, M2. In particular, the battery management system (BMS) 20 is configured to perform cell balancing of the vehicle battery 10, e.g., the two or more battery modules M1, M2, at least derived in part from voltage measurements of the voltage sensor (explained below).

More in particular, the battery management system (BMS) 20 comprises a cell monitoring controller (CMC) 21 and a battery monitoring controller (BMC) 22. The cell monitoring controller (CMC) 21 includes a voltage sensor configured to sense or determine voltage of the two or more battery modules M1, M2. In fact, the voltage sensor comprises a plurality of voltage sensing devices VS1, VS2, each voltage sensing device VS1, VS2 being configured to sense or determine voltage V1, V2, V3 of the plurality of battery cells C1, C2, C3 of the two or more battery modules M1, M2. Also, the cell monitoring controller (CMC) 21 is further configured to perform the cell balancing. Furthermore, the battery monitoring controller (BMC) 22 includes a main (micro)controller which runs algorithms and performs calculations (e.g., the electrochemical impedance spectroscopy).

In examples, the excitation power module 30 is a single excitation power module. The excitation power module 30 is electrically connected to the vehicle battery 10, and the battery management system (BMS) 20. Also, the excitation power module 30 is configured to excite at least two or more battery modules M1, M2. The battery management system (BMS) 20 is particularly configured to instruct or control the excitation power module 30 for generating an excitation input signal. In particular, figure 1 illustrates that the excitation power module 30 is arranged out of an electric circuit involving high electric power, for example, the vehicle battery 10, the junction box 300, and the traction system 410.

As particularly shown in figure 2, the current sensor 40 is (electrically) connected to the two or more battery modules M1, M2. For example, it may be connected directly, such as via a shunt resistor, or indirectly, such as via a Hall sensor. In this way, the current sensor 40 is configured to sense at least electric current (I) of the two or more battery modules M1, M2, particularly, all the battery modules of the vehicle battery 10. Furthermore, the current sensor 40 is electrically connected to the battery management system (BMS) 20. The battery management system (BMS) 20 is thus configured to receive the electric current (I) of the two or more battery modules M1, M2 sensed by the current sensor 40.

In examples, the current sensor 40 is a single-unit current sensor. In particular, the current sensor 40 is electrically connected therebetween the EIS excitation power module 30 and the vehicle battery 10. It is absolutely possible that the current sensor 40 is arranged in the excitation power module 30 or in the vehicle battery 10. As shown, an electric connecting means electrically connects the EIS excitation power module 30 and the vehicle battery 10 to each other. The electric connecting means includes two electric cables or wires, for example, a positive and a negative. The current sensor 40 is (directly) connected to electric connecting means.

The battery management system (BMS) 20 is configured to determine the impedance Z1, Z2, Z3, Z1', Z2', Z3' of the plurality of battery cells C1, C2, C3, C1', C2', C3' of the two or more battery modules M1, M2 based at least on the electric current I and the voltages V1, V2, V3, V1', V2', V3'. Alternatively, the battery management system (BMS) 20 is configured to send the electric current I and the voltages V1, V2, V3, V1', V2', V3' to the external controller 200 configured to determine the impedance Z1, Z2, Z3, Z1', Z2', Z3' of the plurality of battery cells C1, C2, C3, C1', C2', C3' of the two or more battery modules M1, M2 based at least on the electric current I and the voltages V1, V2, V3, V1', V2', V3'.

The battery management system (BMS) 20 or the external controller 200 is configured to determine the electrochemical impedance Z of the vehicle battery 10 (e.g., Z1, Z2, Z3 of the battery cells C1, C2, C3). Particularly, the electrochemical impedance's magnitude and phase is determined by applying Ohm's Law inputting the electric current I and voltages V1, V2, V3 of the vehicle battery cells C1, C2, C3. The determination of the electrochemical impedance Z is conducted under a potentiostatic mode (i.e., applying a constant direct-current potential with a superimposed alternate-current / sine-wave perturbation) or a galvanostatic mode (i.e., applying a constant current with a small non-constant current perturbation).

The battery management system (BMS) 20 or the external controller 200 is further configured to monitor an electrochemical degradation of the battery cells C1, C2, C3 by determining the impedance variation compared to one or more previous measurements of the battery cells C1, C2, C3 (that may include measurements that are performed in the factory or based on previous aging tests). For determining the impedance Z, the battery management system (BMS) 20 or the external controller 200 requires to study a frequency spectra analysis of the impedance Z so as to determine the resistance / reactance value(s) of the battery cells C1, C2, C3. In examples, the EIS excitation power module 30 generates voltage and current signals to the vehicle battery 10 within a frequency range of 0.1 - 4000 Hz. Said voltage and current signals are part of the excitation input signal i(f) that, in examples, comprises a sine-wave or square-wave. Other types of waves are of course possible as long as the excitation input signal i(f) includes perturbations. Then, based on the impedance Z measurements, an impedance curve is obtained, allowing the deduction of an equivalent circuit model (ECM) of the vehicle battery 10 (e.g., of the plurality of battery cells C1, C2, C2). This enables understanding how it has changed or degraded.

The excitation input signal i(f) is generated at cell-level scale, with a single excitation signal for each cell C1, C2, C3 or, alternatively, a single excitation input signal i(f) is generated for multiple cells C1, C2, C3 connected in parallel and/or series groups. The perturbation response (voltage or current) is measured at cell-level C1, C2, C3 to have a successful characterization of the battery cell impedance Z. Alternatively, the perturbation is obtained for multiple cells C1, C2, C3 with one measurement but the precision of the result will decrease. In non-limiting examples, the measured signals go to an analog-to-digital interface to be then processed to calculate the impedance Z. In any case, the excitation input signal i(f) through the battery cells C1, C2, C3 is small enough to not modify the battery cell conditions, alike the state of charge.

The battery management system (BMS) 20 is thus configured to receive or determine voltage and current measurements from the plurality of voltage sensors VS1, VS2 and the current sensor 40 respectively. Then, it is possible for the battery management system (BMS) 20 or the external controller 200 to process said measurements to determine the status of the vehicle battery 10. The battery management system (BMS) 20 or the external controller 200 is also configured to control the contactors 301, 302 of the junction box 300.

In non-limiting examples, the battery management system (BMS) 20 is configured to receive additional measurements of the vehicle battery 10 such as temperature, gas (e.g., H2, CO, CO2), pressure, isolation and leakage. The battery management system (BMS) 20 processes these values which can be transmitted to the external controller 200 through the vehicle bus communication channel, or could be used for internal use.

In examples, tracking the impedance status can be used to enhance the SoH and SoS.

The EIS performs a frequency analysis based on Ohm's Law using voltage and current measurements. EIS can be performed under potentiostatic mode if a voltage excitation input signal is generated at the battery cell level C1, C2, C3 and the current response at the battery modules level M1, M2 is measured. Alternatively, the galvanostatic mode uses a current excitation input signal, and the perturbation is the voltage drop at the cell C1, C2, C3. EIS analysis requires stable conditions for the vehicle battery 10; consequently, the most preferred mode is galvanostatic, as it does not impact the SoC or the temperature of the battery cells C1, C2, C3. EIS should report the impedance curve as a function of frequency for the battery cells C1, C2, C3. The frequency range to be analyzed is of between 0.1 Hz and 1 kHz. However, for practical application, a small number of frequencies (5 to 10) is sufficient to study the evolution of the impedance Z throughout the vehicle battery's lifespan.

To perform galvanostatic EIS, a controlled power module acts as a current source and directly connected to the vehicle battery 10. As illustrated, the system is an independent circuit from the electric power operated system 400. Therefore, the operation of the EIS excitation power module 30 is only possible when the electric power operated system 400 is disconnected from the vehicle battery 10.

As shown in figure 2, the excitation input (EIS current) signal i(f) to the vehicle battery 10 is sensed by the current sensor 40 that reports the signal I to the BMS controller. The battery 10 is composed of different modules M1, M2 where independent voltage measurements for each cell C1, C2, C3 report the voltage response V1, V2, V3 to the BMS controller. Then, the voltage values V1, V2, V3 and the current I are used to calculate the impedance at the cell level Z1, Z2, Z3. These impedance results are then used in algorithms in the BMS or another controller to determine the SoX value and enhance vehicle operation.

EIS is not (essentially) a recurrent analysis, as battery degradation is not abrupt. The test may be performed periodically or when requested by the user or driver or due to an event. Thus, the vehicle controller (BMS) 200 (or the BMC 22) creates a trigger command by itself after a predefined distance, a predefined time, or upon driver instruction. The command is transmitted to the battery management system (BMS) 20 through the vehicle bus communication channel. The BMS 20 registers the request and checks the vehicle status. As noted, EIS must be performed under stable conditions. Consequently, the vehicle has to be stopped, in parking mode, with no connection between the vehicle battery 10 and the motor drivers or charging buses. If the vehicle battery 10 is isolated from the electric power operated system 400 (e.g., the powertrain 410), the BMS 20 sends a wake-up command to the EIS converter controller. The EIS excitation power module 30 is configured with internal predefined parameters, or the BMS 20 commands them. Then, the EIS is performed, with the excitation input current i(f) reported to the BMS 20 (see figure 2), and the voltage perturbations sensed by the CMC 21. Once the EIS is finished, the BMS 20 sends another command to the EIS excitation power module 30 to stop and enter to sleep mode again. Finally, once the impedance data is processed, the predefined distance or timer counters in the external controller 200 (or BMC 22) are reset.

According to Kramers-Kroning conditions, the system may be ensured causal and physically consistent, where for the EIS the main conditions are: Causality, Linearity and Stability. The stability and linearity of the battery cells C1, C2, C3 can be better ensured under galvanostatic analysis, as a small potential perturbation through the battery cells C1, C2, C3 can result in a notable current perturbation response that can influence the battery cell conditions, like state of charge modification, which is a non-stable and non-linear response.

In examples, the battery management system (BMS) 20 is further configured to receive or generate a starting instruction. The starting instruction is based at least on one of a predefined time, predefined distance, and an instruction from the user or driver. For example, the predefined time may be 1 year, and the predefined distance may be 100,000 kilometers. Other times and distances may be of course possible.

The above-mentioned trigger command of the system is further based on the starting instruction. The battery management system (BMS) 20 is configured to receive a vehicle input signal VIS. In particular, the battery management system (BMS) 20 is configured to determine the trigger command based at least on the vehicle input signal VIS. Said vehicle input signal VIS is at least related to the vehicle status and the vehicle-battery status. The vehicle status is at least one of parking mode, ignition off, vehicle not started. The vehicle status serves the purpose of determining whether the vehicle battery receives and/or supplies electric power or not.

In non-limiting examples, the trigger command is further delayed by the pre-set time or up to the temperature of the vehicle battery 10 is lower than a pre-established temperature. Even more in particular, the trigger command is delayed up to the cell balancing is completed.

In any case, the vehicle input signal VIS is received from the external controller 200 or through a vehicle bus communication channel. In examples, the external controller 200 is arranged out of the electrochemical impedance spectroscopy system. Particularly, the battery management system (BMS) 20 or the external controller 200 is configured to receive a change of the vehicle-battery status SOX or the vehicle status. In use, the battery management system

(BMS) 20 or the external controller 200 is configured to stop determining the impedance Z1, Z2, Z3 based on the change of the vehicle-battery status or the vehicle status.

The method for operating an electrochemical impedance spectroscopy system comprises the following steps:
Providing a vehicle battery 10 comprising a first battery module M1, and a second battery module M2. The first battery module M1 includes a plurality of battery cells C1, C2, C3. The second battery module M2 also includes a plurality of battery cells C1', C2', C3'.
Electrically connecting a battery management system (BMS) 20 to the vehicle battery 10. The battery management system (BMS) 20 comprises a cell monitoring controller (CMC) 21 and a battery monitoring controller (BMC) 22.

Forming an electric circuit by electrically connecting at least the first module M1, and an excitation power module 30. The electric circuit may not be a high-voltage electric circuit. Furthermore, the method includes electrically connecting the second module M2 to the electric circuit (i.e., the excitation power module 30, and the first and second modules M1, M2 form said electric circuit).

Electrically connecting the excitation power module 30 to the battery management system (BMS) 20.

Electrically connecting a current sensor 40 to the electric circuit.

Powering the excitation power module 30 configured to excite the electric circuit.

Sensing, by the current sensor 40, electric current I of the electric circuit at least when the electric circuit is being excited.

Receiving, by the battery management system (BMS) 20, the electric current I of the electric circuit sensed by the current sensor 40.

Sensing, determining, or receiving voltage V1, V2, V3 of the plurality of battery cells C1, C2, C3 of the first battery module M1 by the battery management system (BMS) 20.

Sensing, determining, or receiving voltage V1', V2', V3' of the plurality of battery cells C1', C2', C3' of the second battery module M2 by the battery management system (BMS) 20.

Determining the impedance Z1, Z2, Z3, Z1', Z2', Z3' of the plurality of battery cells C1, C2, C3, C1', C2', C3' of the first battery module M1 and the second battery module M2 based at least on the electric current I and the voltage V1, V2, V3, V1', V2', V3' by the battery management system (BMS) 20. Alternatively, it is absolutely possible that the method comprises sending the electric current I and the voltage V1, V2, V3, V1', V2', V3' to an external controller 200 configured to determine the impedance Z1, Z2, Z3, Z1', Z2', Z3' of the plurality of battery cells C1, C2, C3, C1', C2', C3' of the first battery module M1 and the second battery module M2 based at least on the electric current I and the voltage V1, V2, V3, V1', V2', V3'.

The method further comprises:
Receiving a vehicle input signal VIS. The vehicle input signal VIS is at least related to vehicle status and the battery pack status.
Determining a trigger command of the electrochemical impedance spectroscopy system based at least on the vehicle input signal VIS.
Receiving or generating a starting instruction. The trigger command of the electrochemical impedance spectroscopy system is further based on the starting instruction. The starting instruction is based at least on one of a predefined time, a predefined distance, and an instruction from a user or driver.
Connecting the vehicle battery 10, the junction box 300, and the electric power operated system 400 to each other forming a high-voltage electric circuit being different from the above-mentioned electric circuit. In addition, determining the impedance Z1, Z2, Z3, Z1', Z2', Z3' when the contactors 301, 302 and/or relays of the junction box 10 are in open position.

All possible combinations of the examples described herein are also thus covered. The scope of the present disclosure should not be limited by particular examples, but should be determined only by a fair reading of the claims that follow. If reference signs related to drawings are placed in parentheses in a claim, they are solely for attempting to increase the intelligibility of the claim, and shall not be construed as limiting the scope of the claim.

## Claims

1. An electrochemical impedance spectroscopy system comprising:
a vehicle battery (10) comprising one, two or more battery modules (M1, M2), wherein each battery module (M1, M2) includes a plurality of battery cells (C1, C2, C3);
- a battery management system (20) electrically connected to the vehicle battery (10), wherein the battery management system (20) is configured to sense, determine, or receive voltage (V1, V2, V3) of the plurality of battery cells (C1, C2, C3) of the one, two or more battery modules (M1, M2), wherein the battery management system (20) is configured to control the vehicle battery (10);
- an excitation power module (30) electrically connected to the vehicle battery (10) and the battery management system (20), wherein the excitation power module (30) is configured to excite at least the one, two or more battery modules (M1, M2); and
- a current sensor (40) configured to sense at least electric current (I) of the one, two or more battery modules (M1, M2) when excited,
wherein the battery management system (20) is configured to receive the electric current (I) of the one, two or more battery modules (M1, M2) sensed by the current sensor (40), and
wherein the battery management system (20) is configured to determine the impedance (Z1, Z2, Z3) of the plurality of battery cells (C1, C2, C3) of the one, two or more battery modules (M1, M2) based at least on the electric current (I) and the voltage (V1, V2, V3), or
wherein the battery management system (20) is configured to send the electric current (I) and the voltage (V1, V2, V3) to an external controller (200) configured to determine the impedance (Z1, Z2, Z3) of the plurality of battery cells (C1, C2, C3) of the one, two or more battery modules (M1, M2) based at least on the electric current (I) and the voltage (V1, V2, V3).

2. The system of claim 1, wherein the current sensor (40) is a single current sensor electrically connected to two or more battery modules (M1, M2), wherein the current sensor (40) is configured to sense at least electric current of the two or more battery modules (M1, M2).

3. The system of claim 1 or 2, wherein the excitation power module (30) is a single excitation power module, wherein the excitation power module (30) is configured to excite at least two or more battery modules (M1, M2).

4. The system of any of claims 1 - 3, wherein the excitation power module (30) is arranged out of the vehicle battery (10) and the battery management system (20).

5. The system of any of claims 1 - 4, wherein the current sensor (40) is electrically arranged therebetween the excitation power module (30) and the vehicle battery (10) including in the excitation power module (30) or in the vehicle battery (10).

6. The system of any of claims 1 - 5, wherein the battery management system (20) is configured to receive a vehicle input signal (VIS), wherein the vehicle input signal (VIS) is at least related to vehicle status and the vehicle-battery status, and wherein the battery management system (20) is configured to determine a trigger command of the system based at least on the vehicle input signal (VIS).

7. The system of claim 6, wherein the vehicle status is at least one of parking mode, ignition off, vehicle not started, and wherein the vehicle-battery status comprises whether the vehicle battery receives and/or supplies electric power or not.

8. The system of claim 6 or 7, wherein the battery management system (20) is further configured to receive or generate a starting instruction, wherein the trigger command of the system is further based on the starting instruction, preferably, the starting instruction is based at least on one of
- a predefined time,
- predefined distance, and
- an instruction from a user or driver.

9. The system of any of claims 6 - 8, wherein the trigger command of the system is further based on a temperature of the vehicle battery (10) and/or pre-set time, preferably, the trigger command is delayed by the pre-set time or up to the temperature of the vehicle battery (10) is lower than a pre-established temperature.

10. The system of any of claims 6 - 9, wherein the vehicle input signal (VIS) is received from a vehicle control unit (VCU) or through a vehicle bus communication channel, wherein the vehicle control unit (VCU) is arranged out of the system.

11. The system of any of claims 6 - 10, wherein the battery management system (20) or the external controller is configured to receive a change of the vehicle-battery status or the vehicle status, and wherein the battery management system (20) or the external controller is configured to stop determining the impedance (Z1, Z2, Z3) based on the change of the vehicle-battery status or the vehicle status.

12. The system of any of claims 6 - 11, wherein the trigger command of the system is further based on a cell balancing of the vehicle battery (10), preferably, the trigger command is delayed up to the cell balancing is completed.

13. A method of operating an electrochemical impedance spectroscopy system comprising:
- providing a vehicle battery (10) comprising a first battery module (M1) that includes a plurality of battery cells (C1, C2, C3);
- electrically connecting a battery management system (20) to the vehicle battery (10);
- forming an electric circuit by electrically connecting at least the first module (M1), and an excitation power module (30);
- electrically connecting the excitation power module (30) to the battery management system (20);
- electrically connecting a current sensor (40) to the electric circuit;
- powering the excitation power module (30) configured to excite the electric circuit;
- sensing, by the current sensor (40), electric current (I) of the electric circuit at least when the electric circuit is being excited;
- receiving, by the battery management system (20) the electric current (I) of the electric circuit sensed by the current sensor (40);
- sensing, determining, or receiving voltage (V1, V2, V3) of the plurality of battery cells (C1, C2, C3) of the first battery module (M1) by the battery management system (20); and
- determining the impedance (Z1, Z2, Z3) of the plurality of battery cells (C1, C2, C3) of the first battery module (M1) based at least on the electric current (I) and the voltage (V1, V2, V3), by the battery management system (20), or
sending the electric current (I) and the voltage (V1, V2, V3) to an external controller configured to determine the impedance (Z1, Z2, Z3) of the plurality of battery cells (C1, C2, C3) of the one, two or more battery modules (M1, M2) based at least on the electric current (I) and the voltage (V1, V2, V3).

14. The method of claim 13, further comprising:
- providing a second battery module (M2) to the vehicle battery (10) that includes a plurality of battery cells (C1', C2', C3');
- electrically connecting the second module (M2) to the electric circuit;
- sensing or determining voltage (V1, V2, V3, V1', V2', V3') of the plurality of battery cells (C1, C2, C3, C1', C2', C3') of the first battery module (M1) and the second battery module (M2) by the battery management system (20); and
- determining the impedance (Z1, Z2, Z3, Z1', Z2', Z3') of the plurality of battery cells (C1, C2, C3, C1', C2', C3') of the first battery module (M1) and the second battery module (M2) based at least on the electric current (I) and the voltage (V1, V2, V3, V1', V2', V3') by the battery management system (20).

15. The method of claim 13 or 14, further comprising:
- receiving a vehicle input signal (VIS), wherein the vehicle input signal (VIS) is at least related to vehicle status and the battery pack status;
- determining a trigger command of the system based at least on the vehicle input signal (VIS); and
- preferably, receiving or generating a starting instruction, wherein the trigger command of the system is further based on the starting instruction, optionally, the starting instruction is based at least on one of
∘ a predefined time,
∘ predefined distance, and
∘ an instruction from a user or driver.
